# EUROPEAN PATENT APPLICATION

(11) **EP 2 611 274 A2**
(43) Date of publication of application: **03.07.2013**
(21) Application number: 12191979.9
(22) Date of filing: 09.11.2012
(51) Int. Cl.: H05K 9/00

(54) **Electric connector cage**

(30) Priority: 28.12.2011 JP 2011288295
(71) Applicant: HONDA TSUSHIN KOGYO Co., Ltd., Tokyo 152-8520 (JP)
(72) Inventor: Kasahara, Masayuki, Tokyo, 152-8520 (JP)
(74) Representative: Vossius & Partner

(57) **Abstract**

An electric connector cage (1) is disclosed. In order to achieve an accurate positioning of a spring member (3, 5) with respect to a cage body (2) and make operations such as welding easy to perform, the electric connector cage (1) includes the cage body (2) and a grounding spring member (3, 5) to be fixed to a distal end portion of the cage body, and includes one or more sets of a positioning recess (2b, 4a) formed at the distal end portion of the cage body (2) and a positioning projection (3b, 5a) formed to engage a distal end portion of the spring member corresponding to the recess.

## Description

The present invention relates to a cage, which is a shield case for an electric connector to be mounted on a printed circuit board or the like.

Conventionally, it is known a cage, which is a shield case configured to shield an electromagnetic wave having harmful effects on electronic components or optical /electrical connecting portions mounted on a printed circuit board is fixed to the printed circuit board by being press-fitted into a mounting hole formed in the printed circuit board (see JP2004-235529A).

An electric connector cage of the prior art described above has a form in which a spring member or the like is integrated with a cage body and part of the cage body is bent to form a spring contact strip for a reduction of the number of components or a cost reduction.

However, since a distal end portion of the cage body is required to have electromagnetic shielding with a higher performance because the optical /electrical connection is established by an electric connector, a grounding spring member is mounted on and fixed to the cage body by welding or soldering separately from the cage body. Such a configuration is intended for establishing reliable electromagnetic shielding. However, when an attempt is made to place the separate spring member on the cage body and welding the same thereto when performing the operation such as welding, the spring member may be displaced, or moved during the welding operation. Therefore, adequate positioning of the spring member is not easy. There is a fear that the spring member is fixed in a state of being displaced in mounting position, and hence there is a problem that a securing operation such as welding cannot be achieved efficiently.

The spring member needs to be positioned accurately on the cage body and the operation such as welding needs to be performed easily. Accordingly, it is an object of the invention to provide an electric connector cage that is capable of satisfying such requirements.

In order to satisfy the above-described requirements, an electric connector cage according to the invention includes a cage body, and a grounding spring member to be fixed to a distal end portion of the cage body, wherein one or more sets of a positioning recess formed on the distal end portion of the cage body and a positioning projection formed on a distal end portion of the spring member corresponding to the recess so as to engage each other are provided.

It is preferable that the positioning projections are projections having projecting portions bent toward the cage body at a right angle, and the positioning recesses are notched recesses configured to receive the projections because positioning is achieved with a simple configuration.

In order to achieve further stable positioning, it is preferable that the projecting portions of the positioning projections are each a clip portion formed by being bent into a clip shape, and the positioning recesses are each a plate-shaped engaging portion formed to be thinner than the board thickness of the periphery thereof and have an engaging hole where a distal end portion of the clip portion projecting downward is fitted and engaged.

Furthermore, it is preferable that the positioning recesses and the positioning projections are formed over the entire perimeters of the distal end portions of the cage body and the spring member in the circumferential direction.

According to the electric connector cage of the invention, since the positioning recesses and the positioning projections which engage each other are provided on the cage body and the spring member, the spring member is reliably positioned, the securing operation such as welding is performed reliably, and the working efficiency is improved.

In addition, since the positioning is achieved in a simple configuration of the positioning recesses and the positioning projections such as the notched recesses and projections, reduction in cost is resulted.

Since the positioning projection is the clip portion and the positioning recess is the thin plate having the engaging hole, the engaged state in position may be maintained stably.

Furthermore, since the positioning recesses and the projections are provided over the entire perimeters of the distal end portions of the cage body and the spring member in the circumferential direction, a beneficial effect that fixation of the position of the spring member is stabilized and hence the securing operation is further facilitated is guaranteed.
Figs. 1A to 1D illustrate an electric connector cage according to a first embodiment of the invention, and are a plan view, a front view, a left side view, and a right side view, respectively;
Fig. 2 is a partly enlarged view illustrating a distal end side (the left side in Fig. 1A) of the same electric connector cage;
Figs. 3A to 3C illustrate the same electric connector cage and are a bottom view, a back view, and a partly enlarged view of a left corner portion of Fig. 3A, respectively;
Fig. 4A is a plan view illustrating the same electric connector cage, part of a cage body thereof is omitted;
Fig. 4B is a partly enlarged view of a left end edge portion of Fig. 4A;
Fig. 5A is a plan view illustrating a bottom plate of the same electric connector cage;
Fig. 5B is a partly enlarged view of a recess formed on a left end edge portion in Fig. 5A;
Figs. 6A to 6E illustrate a first spring member of the same electric connector cage and are a plan view, a front view, a bottom view, a right side view, and a partly enlarged view of a spring strip and a projection in Fig. 6B, respectively;
Figs. 7A to 7D illustrate a second spring member of the same electric connector cage and are a plan view, a front view, a bottom view, and a right side view, respectively;
Figs. 8A and 8B are a front view and a right side view illustrating a cage body of the same electric connector cage according to another embodiment;
Figs. 9A to 9C are a plan view, a front view, and a right side view, respectively, illustrating a second spring member of an electric connector cage according to a second embodiment of the invention; and
Fig. 10A illustrates a state in which a clip portion of the same second spring member engages a plate-shaped engaging portion of the bottom plate; and
Fig. 10B is a cross-sectional view taken along the line A-A in Fig. 10A.

An electric connector cage according to the invention is configured to be mounted on a printed circuit board by press-fitting or soldering for electromagnetic shielding.

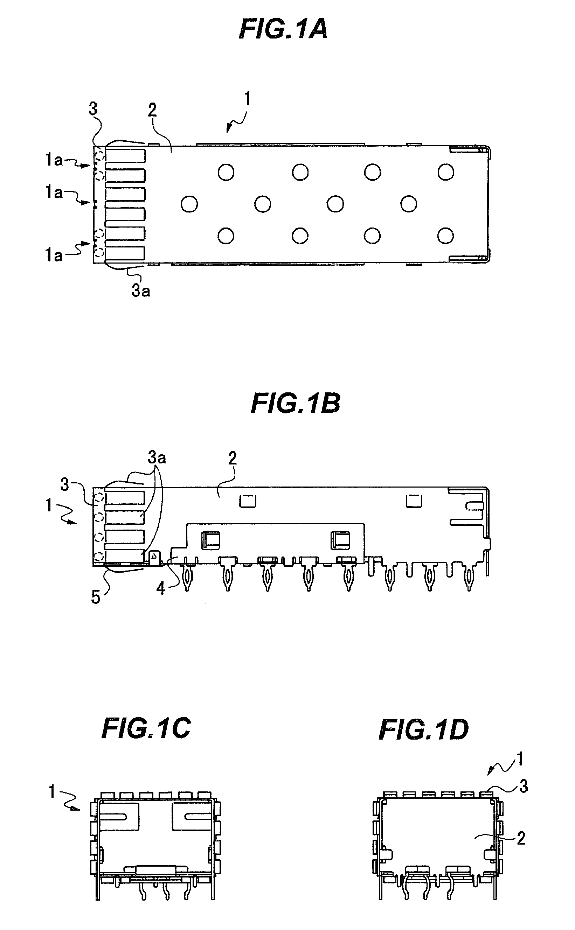

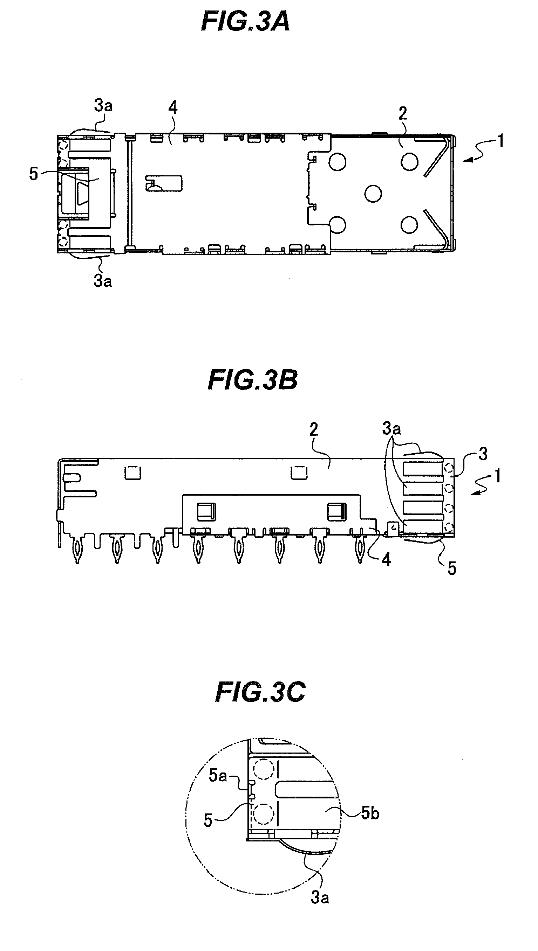

Figs. 1A to 3C illustrate an electric connector cage 1 according to a first embodiment of the invention including a cage body 2 formed of a metallic thin plate, and first and second spring members 3 and 5 for grounding (earth) to be fixed to a distal end portion (left end portions in Figs. 1A and 1B) of the cage body 2 by a securing procedure such as welding or soldering.

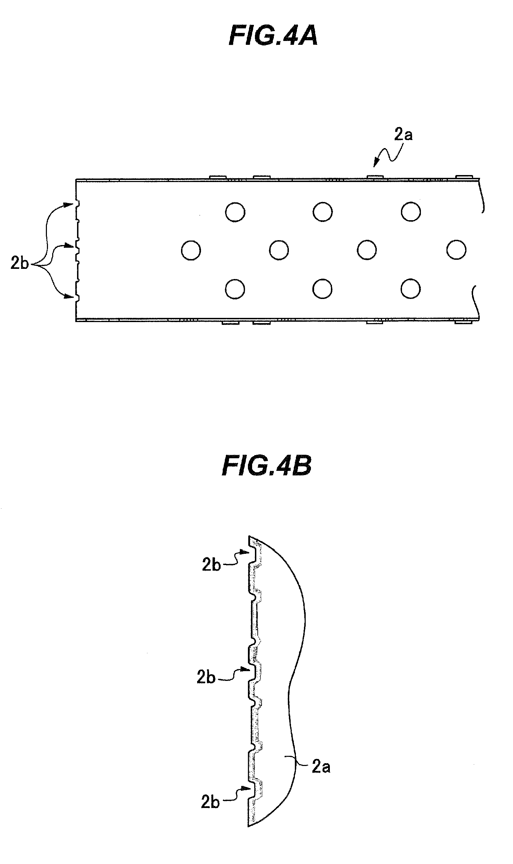

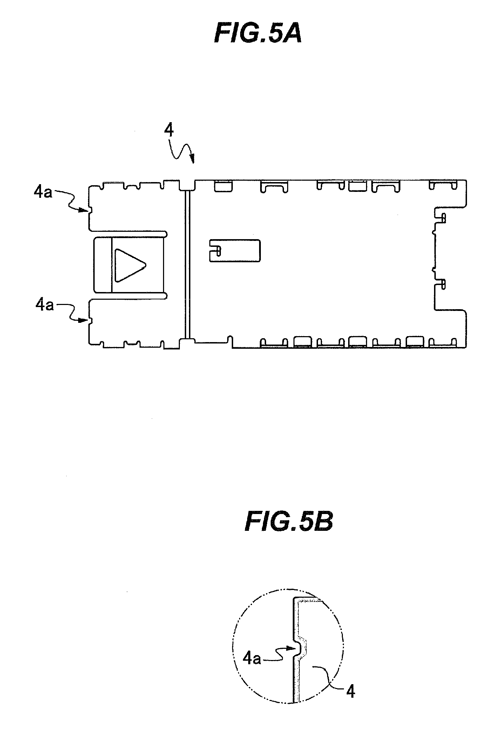

The cage body 2 is formed into a substantially box shape having an opened distal end side, a partly opened bottom surface, and an almost closed rear end side. As illustrated in Figs. 4A and 5A, the cage body 2 is formed by combining a cover member 2a having an inverted U-shape in cross section, and a bottom plate 4.

The cover member 2a and the bottom plate 4 are provided with positioning recesses 2b and 4a at a plurality of positions on respective distal end edges as illustrated in Figs. 4A, 4B, 5A, and 5B. Although the recesses are provided at three positions in this embodiment, the recess or recesses may be provided at one or more suitable positions.

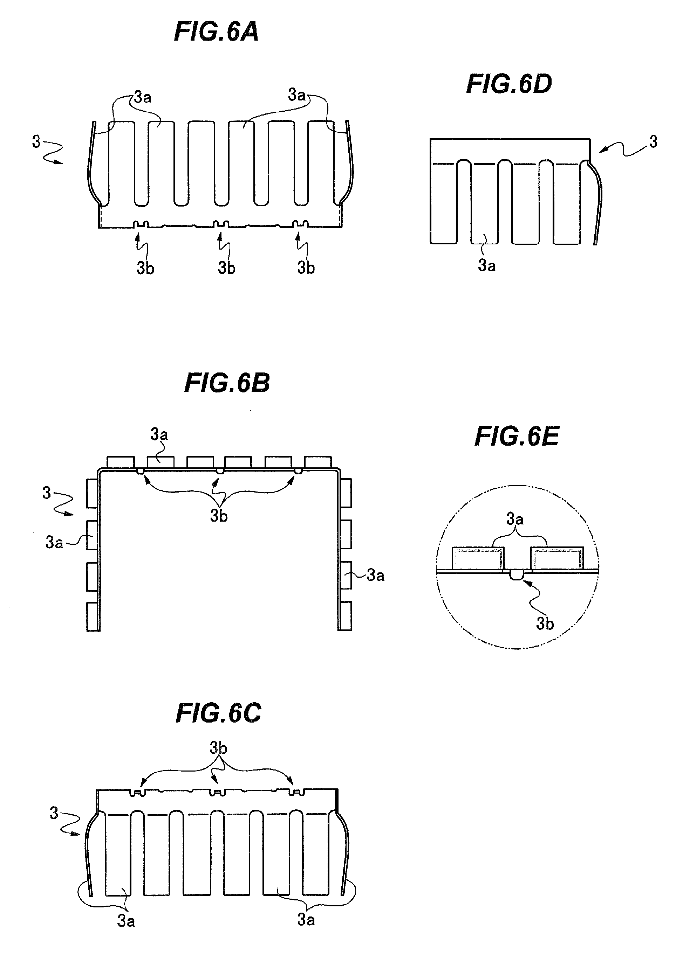

The first spring member 3 is formed of a metallic thin plate integrally as illustrated in Figs. 6A to 6E and includes a number of spring strips 3a bent so as to extend rearward from a band-shaped distal end portion and be curved so as to protrude outward. The band-shaped distal end portion having a form including the spring strips 3a coupled to each other is bent into an inverted U-shape corresponding to the shape of the cover member 2a. Furthermore, a distal end edge portion is formed with projections 3b for positioning engagement at positions corresponding to the recesses 2b of the cover member 2a of the cage body 2 respectively.

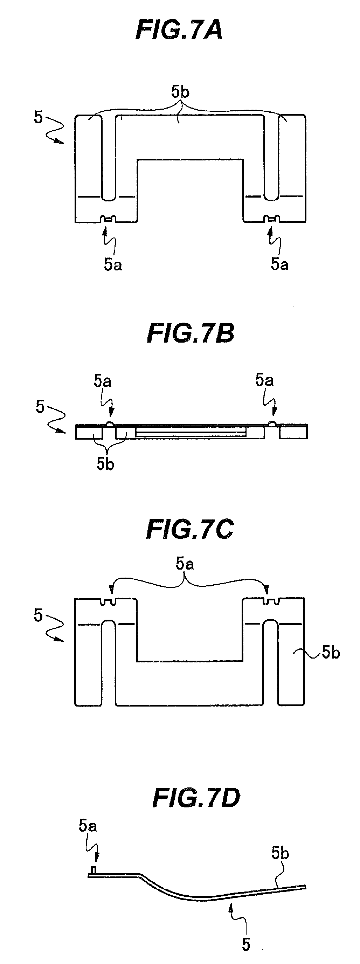

The second spring member 5 is also formed of a metallic plate integrally as illustrated in Figs. 7A to 7D and includes spring strips 5b bent so as to extend rearward from a distal end portion and curved so as to protrude outward. A center portion of the distal end portion of the second spring member 5 is largely cut out, and the distal end portions on both sides and the spring strips 5b are integrally coupled via the spring strip 5b at the center portion. The distal end edge portions on the both sides are formed with positioning projections 5a similar to those on the first spring member 3 at positions corresponding to the recesses 4a formed at a distal end edge of the bottom plate 4.

The respective projections 3b and 5a of the first and second spring members 3 and 5 are bent inward from the distal end portions of the first and second spring members, that is, toward the cage body 2 at a right angle. The invention is not limited to this embodiment, and since the recesses 2b and 4a of the cage body and the projections 3b and 5a of the spring member are positioning recesses and projections, for example, a combination of a semi-circular shaped projection formed on the spring member by half punching and a corresponding semi-circular shaped recess formed by half punching on the side of the cage body 2, which is a counterpart of engagement may be conceivable.

In order to obtain the electric connector cage 1 as illustrated in Figs. 1A to 1D using the cage body 2 and the first and second spring members 3 and 5 as described above, for example, the cover member 2a and the bottom plate 4 are secured in advance by a welding (spot-welding, etc.) procedure to form the cage body 2, the first spring member 3 is placed on an upper surface of the distal end portion of the cage body 2 with the distal end thereof projecting toward the front and is moved rearward in a sliding manner, and the projections 3b are brought into abutment with the recesses 2b of the cage body 2.

As described above, after the positioning of the first spring member 3 is achieved at positioning portions 1 a by the abutment between the recesses 2b and the projections 3b, the first spring member 3 is welded, for example, at four positions by a welding apparatus. Then, the second spring member 5 is secured to the distal end portion of the bottom plate 4 in the same manner by the welding apparatus.

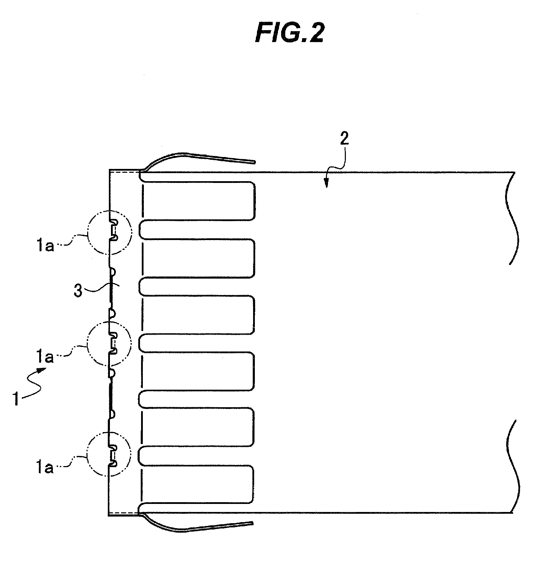

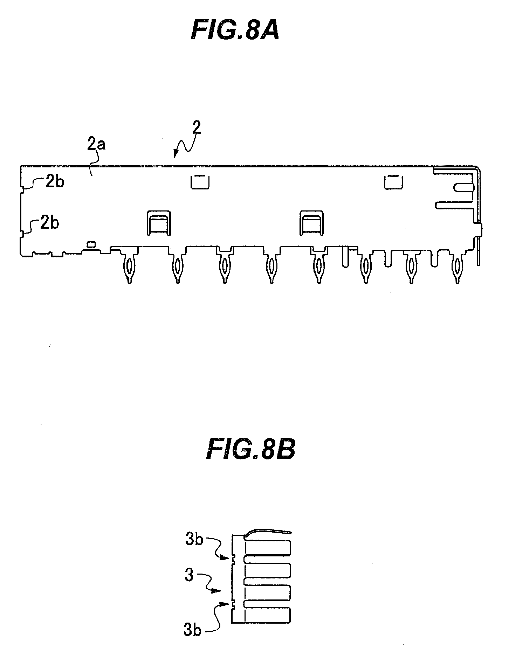

In this manner, the first spring member 3 and the second spring member 5 are positioned on the cage body 2 at the time of the welding operation, and are efficiently secured. Although the positioning portions 1a are provided on the upper surface of the cage body 2 as illustrated in Fig. 2, the invention is not limited thereto, and the positioning portions 1 a may be provided on both side surfaces of the cage body 2 as illustrated Fig. 8A. In this case, in order to achieve the engagement with the positioning portions 1 a, the first spring member 3 is provided with the projections 3b at positions corresponding to the recesses 2b on a side surface thereof. In this manner, it is preferable to provide the positioning portions 1a over the entire perimeters of the distal end portions of the cage body 2 and the spring member (3, 5) in the circumferential direction.

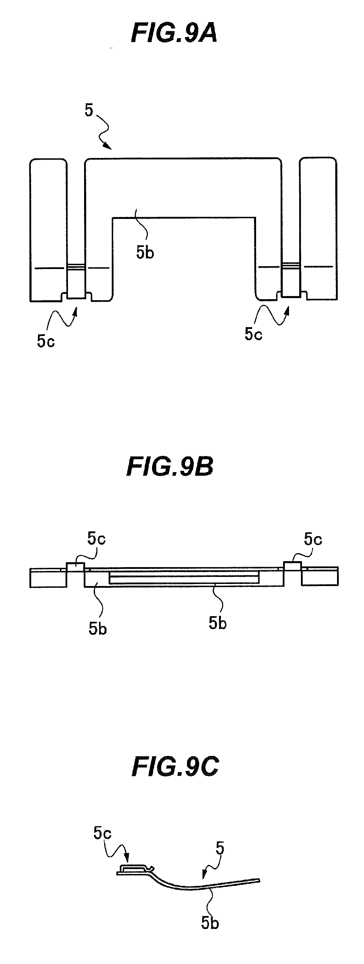

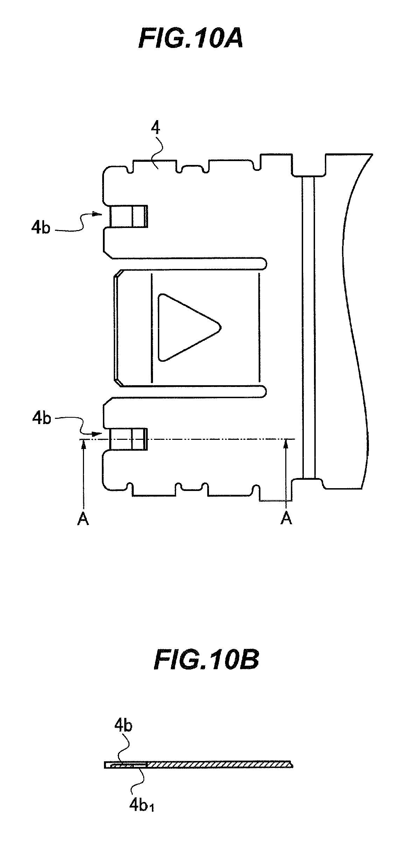

Figs. 9A to 9C illustrate a second spring member 5 used in an electric connector cage according to a second embodiment of the invention. The second spring member 5 is formed with clip portions 5c formed by bending projecting portions into a clip shape instead of the positioning projections in the first embodiment. In contrast, as illustrated in Figs. 10A and 10B, the distal end portion of the bottom plate 4 of the cage body corresponding to the clip portions 5c are formed with plate-shaped engaging portions 4b each reduced in thickness in comparison with the board thickness of the periphery and having an engaging hole 4b₁ which allows fitting engagement of distal end portions of the clip portions 5c projecting downward.

In this configuration, the engagement at the positioning portions 1 a is made further reliable, temporary fixing of the spring member is firmly held, the spring member is prevented from inadvertently moving, and welding operation is efficiently performed.

Although the positioning mode of the second spring member 5 corresponding to the bottom plate 4 of the cage body has been described in this embodiment, it is possible to apply the above-described mode in which the clip portions 5c are provided also to the first spring member corresponding to the cover member 2a.

The electric connector cage according to the invention is widely applied to equipment that ensures the electromagnetic shielding.

## Claims

1. An electric connector cage (1) comprising:
a cage body (2); and
a grounding spring member (3, 5) to be fixed to a distal end portion of the cage body (2), **characterized in that**:
one or more sets of a positioning recess (2b, 4a) formed on the distal end portion of the cage body (2) and a positioning projection (3b, 5a) formed on a distal end portion of the spring member (3, 5) corresponding to the recess (2b, 4a) so as to engage each other are provided.

2. The electric connector cage (1) according to Claim 1, wherein the projecting portions of the positioning projections (3b) are each a projection formed by being bent toward the cage body (2) at a right angle, and
the positioning recesses (2b) each are a notched recess configured to receive the projection.

3. The electric connector cage according to Claim 1, wherein the projecting portions of the positioning projections (5a) are each a clip portion formed by being bent into a clip shape, and the positioning recesses (4a) are each a plate-shaped engaging portion formed to be thinner than the board thickness of the periphery thereof and have an engaging hole (4b₁) where a distal end portion of the clip portion projecting downward is fitted and engaged.

4. The electric connector cage according to any one of Claims 1, 2, and 3, wherein the positioning recesses (2b, 4a) and the positioning projections (3b, 5a) are formed over the entire perimeters of the distal end portions of the cage body (2) and the spring member (3, 5) in the circumferential direction.
